# EUROPEAN PATENT APPLICATION

(11) **EP 2 639 284 A1**
(43) Date of publication of application: **18.09.2013**
(21) Application number: 12173740.7
(22) Date of filing: 27.06.2012
(51) Int. Cl.: C09K 11/77, H05B 33/14

(54) **Luminaire**

(30) Priority: 13.03.2012 JP 2012056396
(71) Applicant: Toshiba Lighting & Technology Corporation, Yokosuka-shi Kanagawa 237-8510 (JP)
(72) Inventor: Nishimura, Kiyoshi, Kanagawa, 237-8510 (JP); Watanabe, Miho, Kanagawa, 237-8510 (JP); Ishiwata, Tomoko, Kanagawa, 237-8510 (JP)
(74) Representative: Bokinge, Ole

(57) **Abstract**

According to one embodiment, a luminaire includes a light-emitting part (110) to emit a blue light with a peak wavelength of 430 nanometers or more and less than 460 nanometers, and a phosphor that is excited by the emitted light of the light-emitting part (110) and emits a light having a color different from blue. In an emission spectrum including the emitted light of the light-emitting part and the light emitted from the phosphor, an intensity peak in a range of a light wavelength of 430 nanometers to 490 nanometers is in a range of a wavelength of 470 nanometers to 490 nanometers.

## Description

### FIELD

Embodiments described herein relate generally to a luminaire.

### BACKGROUND

A luminaire using a semiconductor light source typified by a blue light emitting diode (LED) becomes popular. Particularly, a white light source to emit a mixed light of a blue light from a blue LED and a light emitted from a phosphor excited by the blue light is easily miniaturized and a circuit structure can be simplified. Therefore, the white light source can be used in a variety of uses.

However, the wavelength of the blue light to excite the phosphor is located in a short wavelength region in which a human luminosity factor is lowered. Thus, in illumination with high color temperature, the blue light not contributing to the luminosity factor is increased, and light-emitting efficiency is decreased. Besides, as the wavelength of the blue light becomes short, a possibility that influence such as discoloration is exerted on an irradiation target object becomes high.

### BRIEF DESCRIPTION OF THE DRAWINGS

FIGS. 1A and 1B are schematic sectional views showing a luminaire of a first embodiment.
FIG. 2 is a graph showing an emission spectrum of the luminaire of the first embodiment.
FIGS. 3A and 3B are schematic sectional views showing light-emitting parts of modified examples of the first embodiment.
FIG. 4 is a schematic sectional view showing a luminaire of a modified example of the first embodiment.
FIG. 5 is a schematic sectional view showing a light-emitting part of a second embodiment.
FIG. 6 is a schematic sectional view showing a light-emitting part of a third embodiment.
FIG. 7 is a graph showing an emission spectrum of the light-emitting part of the third embodiment.

### DETAILED DESCRIPTION

According to one embodiment, a luminaire includes a light-emitting part 110 to emit a blue light with a peak wavelength of 430 nanometers or more and less than 460 nanometers, and a phosphor that is excited by the emitted light of the light-emitting part 110 and emits a light having a color different from blue. In an emission spectrum including the emitted light of the light-emitting part and the light emitted from the phosphor, an intensity peak in a range of a light wavelength of 430 nanometers to 490 nanometers is in a range of a wavelength of 470 nanometers to 490 nanometers.

Hereinafter, embodiments will be described with reference to the drawings. Incidentally, the same portion in the drawings is denoted by the same reference numeral, and a detailed description thereof will be suitably omitted, while a different portion will be described.

### First Embodiment

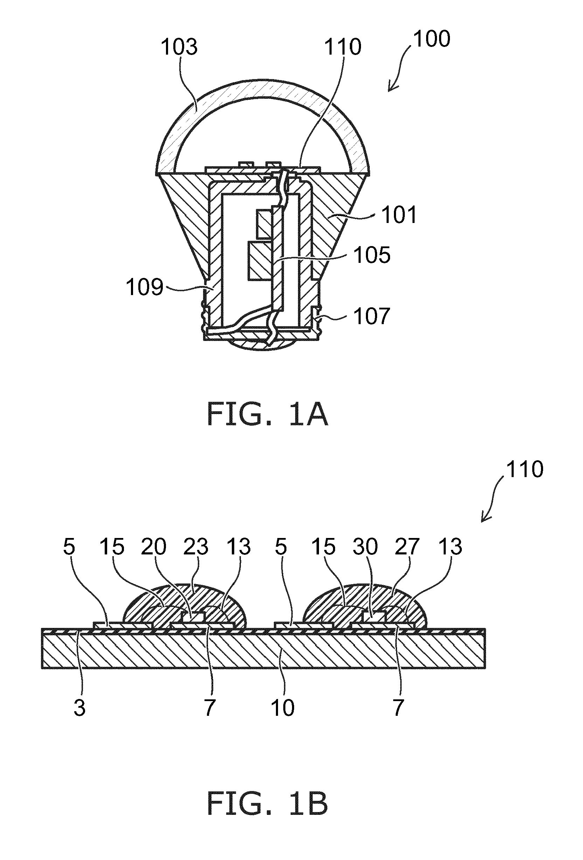

FIG. 1A is a schematic sectional view showing a luminaire 100 of a first embodiment. As shown in the drawing, the luminaire 100 is, for example, a bulb-type lamp, and includes a light-emitting part 110, a housing 101, and a cover 103 to cover the light-emitting part 110.

A power conversion part 105 to supply power to the light-emitting part 110 is provided inside the housing 101, and is electrically connected to the light-emitting part 110 and a cap 107 through a lead wire. Besides, the power conversion part 105 is accommodated in an insulating case 109 provided inside the housing 101.

The power conversion part 105 is supplied with AC power from a not-shown commercial power supply through the cap 107, converts the power to, for example, DC power and supplies the power to the light-emitting part 110.

As shown in FIG. 1B, the light-emitting part 110 includes a first semiconductor light source 20 mounted on a base 10 and a second semiconductor light source 30.

The base 10 is, for example, a metal plate, and the upper surface thereof is coated with an insulating layer 3. The insulating layer 3 is made of, for example, a white resin containing titanium oxide, and reflects upward the emitted light of the first semiconductor light source 20 and the emitted light of the second semiconductor light source.

A positive electrode 5 and a negative electrode 7 are provided on the insulating layer 3. The positive electrode 5 and the negative electrode 7 are made of, for example, copper foils, and the surfaces thereof are plated with silver. By this, the emitted light of the first semiconductor light source 20 and the emitted light of the second semiconductor light source 30 are reflected upward.

The first semiconductor light source 20 and the second semiconductor light source 30 are, for example, blue LED chips made of a GaN nitride semiconductor formed on a sapphire substrate, and are mounted on the negative electrodes 7 by using transparent adhesives. The first semiconductor light source 20 and the second semiconductor light source 30 include not-shown p-electrodes and n-electrodes on the upper surfaces thereof, and the p-electrodes are respectively electrically connected to the positive electrodes 5 through metal wires 15. Besides, the n-electrodes are respectively electrically connected to the negative electrodes 7 through metal wires 13.

The first semiconductor light source 20 and the second semiconductor light source 30 are supplied with DC power from the power conversion part through the positive electrodes 5 and the negative electrodes 7, and respectively emit lights in a blue wavelength region. Although the blue wavelength region is not uniquely determined, here, the wavelength region is 430 nanometers (nm) or more and less than 490 nm. The second semiconductor light source 30 emits a light with a longer wavelength than that of the first semiconductor light source in the blue wavelength region.

Further, the luminaire 100 includes a phosphor which is excited by the emitted light of the first semiconductor light source 20 and emits a light with a longer wavelength than the blue wavelength region. Specifically, for example, as shown in FIG. 1B, the first semiconductor light source 20 is sealed with a transparent resin 23 (first resin) in which the phosphor is dispersed. As the phosphor, for example, a YAG phosphor (yttrium aluminum garnet phosphor) can be used. By this, the phosphor contained in the transparent resin 23 is excited by the light emitted by the first semiconductor light source 20, and emits the light with a wavelength longer than 490 nm.

On the other hand, the second semiconductor light source 30 is sealed with a transparent resin 27 (second resin) dispersed with a scattering material such as silica. As the transparent resins 23 and 27, for example, silicone can be used. Uniform amounts of the transparent resins 23 and 27 are supplied by using a dispenser or the like. By this, the transparent resin 23 for sealing the first semiconductor light source 20 and the transparent resin 27 for sealing the second semiconductor light source 30 can be formed to have the same shape. The luminous intensity distribution of the emitted light of the first semiconductor light source 20 and the luminous intensity distribution of the emitted light of the second semiconductor light source 30 can be made coincident with each other.

Here, that the luminous intensity distributions are coincident with each other includes not only a strict coincidence but also a rough coincidence. For example, the first semiconductor light source 20 and the second semiconductor light source 30 are arranged to be close to each other on the base 10, so that the respective luminous intensity distributions can be made roughly coincident with each other. Further, the first semiconductor light source 20 and the second semiconductor light source 30 are sealed with the transparent resins 23 and 27, so that the respective luminous intensity distributions can be made closer to each other.

As stated above, the luminous intensity distribution of the first semiconductor light source 20 is made coincident with the luminous intensity distribution of the second semiconductor light source 30, so that emission spectra become uniform, and a color shift between the emitted lights can be suppressed.

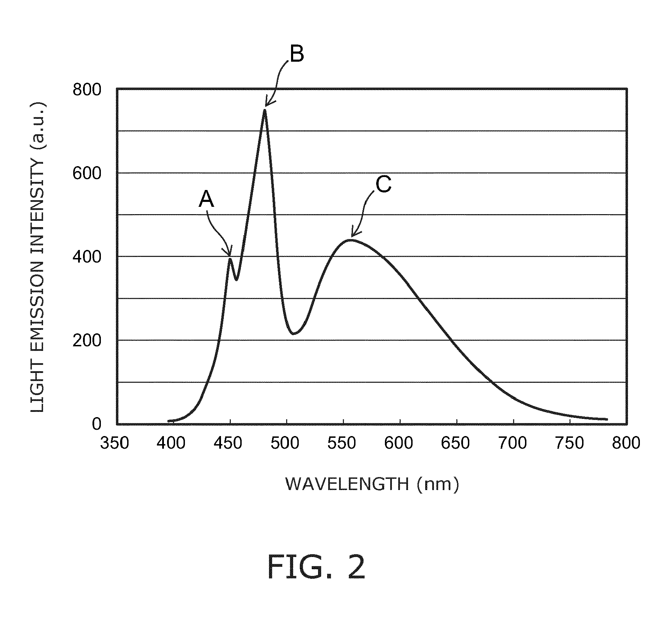

As stated above, the luminaire 100 emits white light in which the emitted light of the first semiconductor light source 20, the emitted light of the second semiconductor light source 30 and the emitted light of the phosphor are mixed with each other. FIG. 2 is a graph showing an example of the emission spectrum of the luminaire 100. The vertical axis indicates light intensity, and the horizontal axis indicates light wavelength.

In the example shown in FIG. 2, the emission spectrum of the luminaire 100 includes three peaks A, B and C. The peak A corresponds to the peak wavelength of the first semiconductor light source 20 and occurs in the vicinity of a wavelength of 450 nm. On the other hand, the peak B corresponds to the peak wavelength of the second semiconductor light source 30 and occurs in the vicinity of a light wavelength of 480 nm. The peak C is the peak of the emission spectrum of the YAG phosphor and occurs in a yellow wavelength region in the vicinity of a light wavelength of 550 nm. That is, the luminaire 100 emits the white light in which the blue lights of the first semiconductor light source 20 and the second semiconductor light source 30 and the yellow light of the phosphor are mixed with each other.

For example, the excitation efficiency of a phosphor of YAG or the like is high at a short wavelength of a light wavelength of 450 nm or less, and is significantly lowered at a light wavelength of 460 nm or more. Thus, the peak wavelength of the emitted light of the first semiconductor light source 20 to excite the phosphor is preferably 430 nm or more and less than 460 nm.

On the other hand, the human luminosity factor has a peak in the vicinity of a light wavelength of 550 nm, and becomes low as the wavelength becomes short. For example, the luminosity factor at a short wavelength side of a light wavelength of 460 nm is half or less of the luminosity factor at a light wavelength of 490 nm. Thus, if the contribution of the emitted light of the first semiconductor light source 20 to color rendering properties is made large, the light-emitting efficiency is lowered.

Incidentally, the light-emitting efficiency in the present specification is a conversion efficiency obtained by multiplying the luminosity factor, and when the ratio of emitted light in a wavelength region where a luminosity factor is low increases, the light-emitting efficiency becomes low.

For example, if the intensity of light emitted from the YAG phosphor is the same, when the color rendering properties of light including the blue light with a wavelength of 480 nm and the emitted light of the phosphor is reproduced by using the blue light with a wavelength 450 nm and the emitted light of the phosphor, the intensity of the blue light with a wavelength of 450 nm is twice or more as high as the intensity of the blue light with a wavelength of 480 nm. That is, if the light-emitting efficiencies of the semiconductor light sources are the same, power contributing to the color rendering properties in the power consumption of the semiconductor light source with a wavelength of 450 nm is twice or more the power consumption of the semiconductor light source with a wavelength of 480 nm.

Then, as shown in FIG. 2, it is preferable that the light intensity of the second semiconductor light source having a luminosity factor higher than the first semiconductor light source 20 is made high and is made to contribute to the color rendering properties. Besides, the peak wavelength of the emitted light of the second semiconductor light source 30 is preferably 470 nm or more and less than 490 nm. Besides, most of the emitted light of the first semiconductor light source 20 is used for the excitation of the phosphor, and the emission spectrum may be such that the peak A does not occur.

The luminaire 100 of the embodiment includes the light-emitting part 110 including the semiconductor light sources 20 and 30, and the phosphor dispersed in the transparent resin 23. The phosphor receives the light with the shortest peak wavelength among the emitted light emitted from the light-emitting part 110 and emits light.

In the emission spectrum including the emitted light of the light-emitting part 110 and the light emitted from the phosphor, preferably, the intensity peak in the range of a light wavelength of 430 nm to 490 nm is in a range of a wavelength of 470 nm to 490 nm. This is not limited to a case where the peak B of the emission spectrum shown in FIG. 2 is in the range of a wavelength of 470 nm to 490 nm, and the maximum value of the emission intensity may be in the range of a wavelength of 470 nm to 490 nm.

Besides, although the embodiment shows the example in which the first semiconductor light source 20 is sealed with the transparent resin 23 containing the phosphor, no limitation is made to this. For example, the phosphor may be arranged separately from the light-emitting part 110.

In this embodiment, the light-emitting efficiency can be enhanced without lowering the color rendering properties of the luminaire 100. Besides, the emission spectrum as stated above is effective in the illumination with high color temperature in which the contribution of blue light is large, and the color temperature is preferably, for example, 3500 K (Kelvin) or more and 7000 K or less.

Further, in the embodiment, the damage given to an irradiation target object is suppressed. That is, as the light wavelength become short, the light energy becomes high, and the damage such as discoloration can be given to the irradiation target object. As stated above, in the luminaire 100, the intensity of the short wavelength light directly emitted from the first semiconductor light source 20 is controlled. By this, the damage to the irradiation target object can be reduced. Accordingly, the luminaire can be used for, for example, spot illumination of an art object.

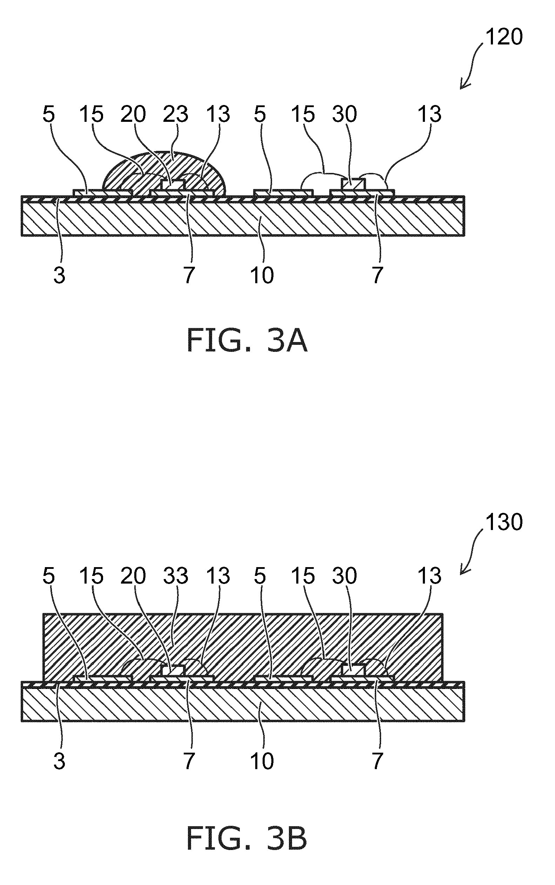

Next, a luminaire of a modified example of this embodiment will be described. FIG. 3A is a schematic sectional view showing a light-emitting part 120 of a first modified example. FIG. 3B is a schematic sectional view showing a light-emitting part 130 of a second modified example.

In the light-emitting part 120 shown in FIG. 3A, a first semiconductor light source 20 is sealed with a transparent resin 23 containing a phosphor. On the other hand, a second semiconductor light source 30 is not sealed with a resin, and directly emits light. By this, a manufacture process can be simplified, and a manufacture cost can be reduced.

In the light-emitting part 130 shown in FIG. 3B, both a first semiconductor light source 20 and a second semiconductor light source 30 are sealed with an integral transparent resin 33. The transparent resin 33 is, for example, silicone, and includes a phosphor. The excitation efficiency of the phosphor by the emitted light of the first semiconductor light source 20 is higher than the excitation efficiency of the phosphor by the emitted light of the second semiconductor light source 30. For example, when the peak wavelength of the emitted light of the first semiconductor light source 20 is 430 nm or more and less than 460 nm, the phosphor dispersed in the transparent resin 33 is excited, and fluorescent light with a wavelength of 490 nm or more is emitted. On the other hand, when the peak wavelength of the emitted light of the second semiconductor light source 30 is 470 nm or more and 490 nm or less, the light is emitted upward without being absorbed by the phosphor dispersed in the transparent resin 33.

By this, the first semiconductor light source 20 and the second semiconductor light source 30 can be arranged to be closer to each other. That is, a luminaire 300 can be easily miniaturized. Further, the amount of the phosphor contained in the transparent resin 33 can be increased, and the absorption of the emitted light of the first semiconductor light source can be increased. By this, the short wavelength light emitted from the first semiconductor light source can be reduced.

As described in the above embodiment, each of the luminaires 100 to 300 includes the first semiconductor light source 20 to excite the phosphor and the second semiconductor light source 30 contributing to the color rendering properties. By this, the light-emitting efficiency is enhanced, and the damage of an irradiation target object can be suppressed. Besides, if only the first semiconductor light source excites the phosphor, the role can be said to be played. That is, all of the blue light emitted from the first semiconductor light source may be absorbed by the phosphor.

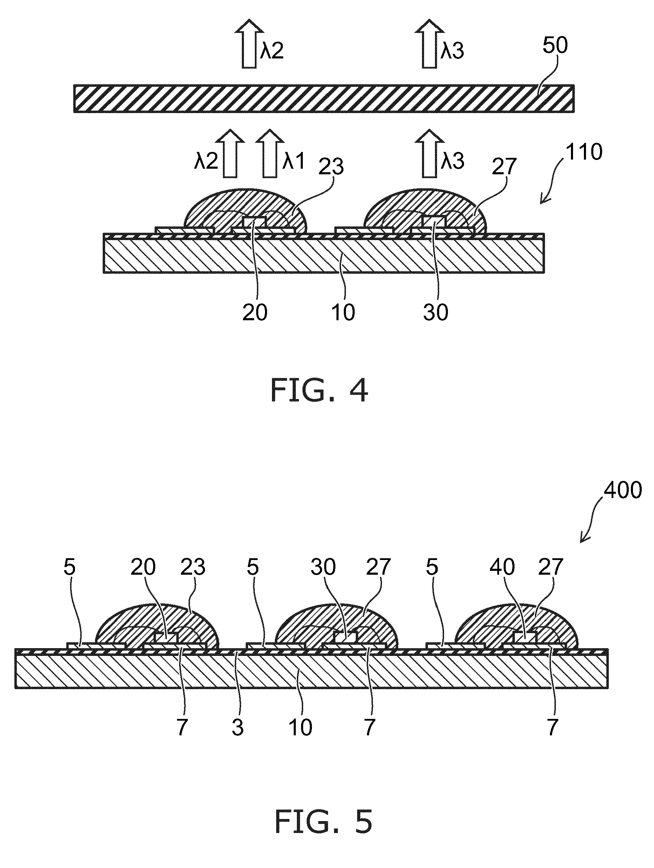

FIG. 4 is a schematic sectional view showing a modified example of the luminaire 100 of the first embodiment. The luminaire 100 includes a filter 50 to attenuate, for example, an emitted light having a wavelength shorter than a wavelength of 460 nm and emitted by a first semiconductor light source 20.

As shown in FIG. 4, the filter 50 blocks a short wavelength blue light λ₁ emitted by the first semiconductor light source, and allows a long wavelength light λ₂ emitted from the phosphor dispersed in the transparent resin 23 and a blue light λ₃ emitted by the second semiconductor light source 30 to pass through. By this, the short wavelength blue light is suppressed, and the damage of an irradiation target object can be further reduced.

For example, a material to absorb light with a wavelength of less than 460 nm may be used for the filter 50, or a material to reflect light with a wavelength of less than 460 mm may be used. The filter 50 is arranged to extend in a direction crossing the emission direction of the light-emitting part 110. For example, the filter may be coated on a cover 103 covering the light-emitting part 110.

### Second Embodiment

FIG. 5 is a schematic sectional view showing a light-emitting part 140 of a second embodiment. The light-emitting part 140 includes a first semiconductor light source 20, a second semiconductor light source 30 and a third semiconductor light source 40.

The first semiconductor light source 20 emits light in a blue wavelength region, and the second semiconductor light source 30 emits light with a longer wavelength than the first semiconductor light source 20 in the blue wavelength region. The third semiconductor light source 40 emits light in a red wavelength region.

The red wavelength region is a wavelength range of a light wavelength of 600 nm or more and 650 nm or less. The emission spectrum of the third semiconductor light source 40 has a peak wavelength in a wavelength range of a light wavelength of 600 nm or more and 650 nm or less.

The respective semiconductor light sources are mounted on, for example, a base 10. As shown in FIG. 5, the first semiconductor light source 20 is sealed with a transparent resin 23 containing a phosphor. The emission spectrum of the phosphor in the embodiment, for example, has a peak in a wavelength range of 490 nm or more and less than 600 nm. Specifically, for example, a sialon (SiAlON) phosphor emitting green fluorescent light can be used.

The second semiconductor light source 30 and the third semiconductor light source 40 are respectively sealed with transparent resins 27 containing a scattering material such as silica. Besides, as shown in FIG. 3A, a configuration in which resin sealing is not performed may be adopted.

The first semiconductor light source 20, the second semiconductor light source 30 and the third semiconductor light source 40 are mounted on the upper surface of the base 10, so that the respective luminous intensity distributions can be roughly made coincident with each other. Besides, the respective semiconductor light sources are sealed with the transparent resins 23 and 27 having the same shape, so that the respective luminous intensity distributions can be made closer to each other.

The light-emitting part 140 emits white light in which the blue light of the second semiconductor light source 30, the red light of the third semiconductor light source 40 and the green light of the phosphor are mixed with each other. Further, the intensity of the emitted light of the phosphor can be controlled by controlling the light-emitting intensity of the first semiconductor light source 20, and the intensities of the blue light and the red light can be controlled by controlling the light-emitting intensities of the second semiconductor light source 30 and the third semiconductor light source 40. By this, in the light-emitting part 140, the color of the emitted light can be arbitrarily controlled.

### Third Embodiment

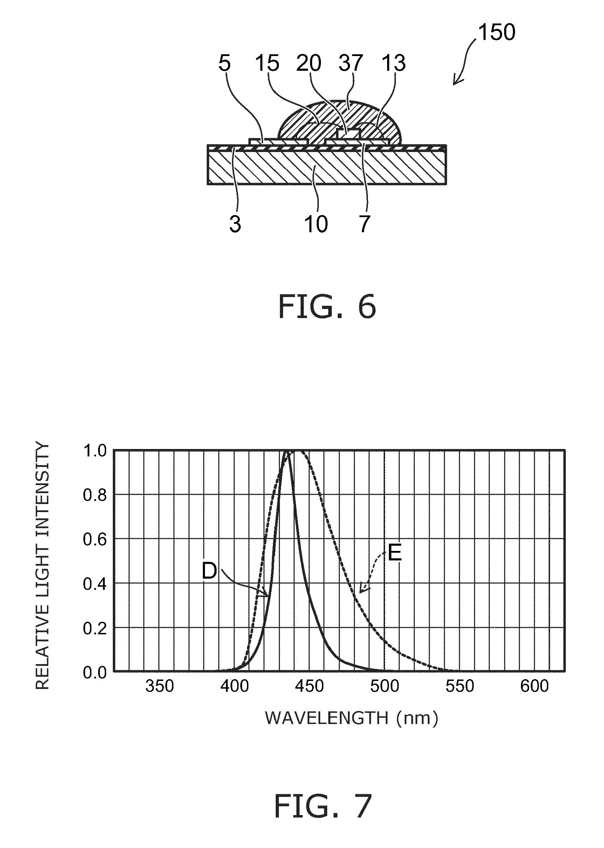

FIG. 6 is a schematic sectional view showing a light-emitting part 150 of a third embodiment. The light-emitting part 150 includes a first semiconductor light source 20 mounted on a base 10. The first semiconductor light source 20 is sealed with a transparent resin 37 containing a first phosphor and a second phosphor.

The first phosphor is excited by the first semiconductor light source 20 emitting a light in a blue wavelength region, and emits light with a longer wavelength than the emitted light of the first semiconductor light source 20 in the blue wavelength region. The second phosphor is excited by the emitted light of the first semiconductor light source 20, and emits light with a longer wavelength than the blue wavelength region. For example, the first phosphor is a BAM phosphor and contains BaMg₂Al₁₆O₂₇:Eu²⁺. The second phosphor is, for example, a YAG phosphor.

FIG. 7 is a graph showing a light emitting spectrum D of the first semiconductor light source 20 and an emission spectrum E of the first phosphor.

The peak wavelength of the emitted light of the first semiconductor light source is between a wavelength of 430 nm and 440 nm, and the half-width of the light emitting spectrum is about 20 nm. By this, the first phosphor and the second phosphor are efficiently excited.

On the other hand, the emission spectrum of the first phosphor containing BaMg₂Al₁₆O₂₇:Eu²⁺ has a peak between a wavelength of 330 nm and 450 nm, and the half-width thereof is 30 nm or more, which is wider than the half-width of the light-emitting peak of the first semiconductor light source. As shown in FIG. 7, the first phosphor emits continuous light in a wavelength range of 460 nm to 500 nm.

The light-emitting part 150 emits white light in which the blue light emitted by the first semiconductor light source 20, the yellow light emitted by the second phosphor (YAG phosphor), and the light with a wavelength of 460 nm to 500 nm emitted by the first phosphor are mixed with each other. By this, the blue light with a short wavelength emitted by the first semiconductor light source 20 is suppressed, and the light-emitting efficiency is enhanced. Further, the damage of an irradiation target object can be suppressed.

As stated above, the embodiment includes the semiconductor light source to emit the blue light having the high excitation efficiency of the phosphor, for example, the light with a wavelength of 430 nm or more and 460 nm or less, and the phosphor to emit the light having the peak wavelength longer than the peak wavelength of the emitted light of the semiconductor light source and less than 490 nm. By this, the luminaire is realized in which the light-emitting efficiency is enhanced by controlling the short wavelength blue light, and the damage to an irradiation target object can be reduced. Further, the filter 50 to block the light with a wavelength of less than 460 nm is combined, so that the damage to an irradiation target object can be further reduced.

The luminaire according to the first embodiment to the third embodiment suppresses the blue light having high light energy and a wavelength of 430 nm to 460 nm, and has the emission spectrum including the blue light having the intensity peak in a range of 470 nm to 490 nm in which the luminosity factor is high. By this, the luminaire is realized in which the power consumption is reduced, and the color rendering properties are improved. Further, the blue light having high energy is suppressed, so that deterioration, such as discoloration, of an irradiation target object can be suppressed.

Although the embodiments show the luminaire in which the LED chip is mounted on the base 10, no limitation is made to this. For example, a semiconductor light source mounted on an SMD (Surface Mount Device) type package may be used. Besides, a semiconductor light source mounted on a shell-type package may be combined.

Although exemplary embodiments have been described, these embodiments have been presented by way of example only, and are not intended to limit the scope of the invention. Indeed, these novel embodiments can be carried out in a variety of other forms, and various omissions, substitutions and changes can be made within the scope not departing from the gist of the invention. These embodiments and modifications thereof fall within the scope and the gist of the invention and fall within the scope of the invention recited in the claims and their equivalents.

## Claims

1. A luminaire comprising:
a light-emitting part (110) to emit a blue light with a peak wavelength of 430 nanometers or more and less than 460 nanometers; and
a phosphor that is excited by the emitted light emitted from the light-emitting part (110) and emits a light having a color different from blue, wherein
in an emission spectrum including the emitted light of the light-emitting part (110) and the light emitted from the phosphor, an intensity peak in a range of a light wavelength of 430 nanometers to 490 nanometers is in a range of a wavelength of 470 nanometers to 490 nanometers.

2. The luminaire of claim 1, wherein color temperature of light having the emission spectrum is 3500 Kelvin or more and 7000 Kelvin or less.

3. The luminaire of claim 1 or 2, wherein
the light-emitting part (110) includes a first semiconductor light source (20) in which a peak wavelength of the emitted light is 430 nanometers or more and less than 460 nanometers, and a second semiconductor light source (30) in which a peak wavelength of the emitted light is 470 nanometers or more and less than 490 nanometers, and
a spectrum of the phosphor has a peak at a wavelength of 490 nanometers or more.

4. The luminaire of claim 3, wherein the first semiconductor light source (20) is sealed with a first resin (23) containing the phosphor, and the second semiconductor light source (30) is sealed with a second resin (27) containing a scattering material.

5. The luminaire of claim 3, wherein an excitation efficiency of the phosphor by the emitted light of the first semiconductor light source (20) is higher than an excitation efficiency of the phosphor by the emitted light of the second semiconductor light source (30).

6. The luminaire of claim 5, wherein the first semiconductor light source (20) and the second semiconductor light source (30) are sealed with a resin (33) containing the phosphor.

7. The luminaire of any one of claims 3 to 6, wherein luminous intensity distributions of the first semiconductor light source (20) and the second semiconductor light source (30) are coincident with each other.

8. The luminaire of any one of claims 3 to 7, further comprising a base (10) on which the first semiconductor light source (20) and the second semiconductor light source (30) are mounted.

9. The luminaire of any one of claims 1 to 8, wherein the phosphor has a characteristic to emit the light having a longer wavelength than the peak wavelength of the emitted light of the semiconductor light source and having a peak wavelength of less than 490 nanometers.

10. The luminaire of claim 9, wherein the peak wavelength of the emitted light of the first semiconductor light source (20) is 430 nanometers or more and 440 nanometers or less.

11. The luminaire of claim 9 or 10, wherein a half-width of the light emitted by the phosphor is wider than a half-width of the light-emitting peak of the first semiconductor light source (20).

12. The luminaire of any one of claims 9 to 11, wherein the phosphor contains BaMg₂Al₁₀O₂₇:Eu²⁺.

13. The luminaire of any one of claims 9 to 12, wherein the phosphor emits the light having a continuous emission spectrum in a range of a wavelength of 460 nanometers to 500 nanometers.

14. The luminaire of any one of claims 1 to 13, wherein the phosphor contains a YAG phosphor.

15. The luminaire of any one of claims 1 to 14, further comprising a filter (50) to attenuate the emitted light having a shorter wavelength than a wavelength of 460 nanometers emitted by the light-emitting part (110).
